(19) Europäisches Patentamt
European Patent Office
Office européen des brevets

(11) **EP 3 088 723 B1**

(12) **EUROPÄISCHE PATENTSCHRIFT**

(45) Veröffentlichungstag und Bekanntmachung des Hinweises auf die Patenterteilung:
**12.06.2019 Patentblatt 2019/24**

(21) Anmeldenummer: **16165743.2**

(22) Anmeldetag: **18.04.2016**

(51) Int Cl.:
*F02M 57/00* $^{(2006.01)}$    *H01L 41/083* $^{(2006.01)}$
*H01L 41/047* $^{(2006.01)}$    *H01L 41/273* $^{(2013.01)}$
*G01L 23/10* $^{(2006.01)}$    *H01L 41/113* $^{(2006.01)}$
*H01L 41/293* $^{(2013.01)}$

(54) **KRAFTSTOFFINJEKTOR**

FUEL INJECTOR

INJECTEUR DE CARBURANT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.04.2015 DE 102015208063**
           **18.06.2015 DE 102015211186**

(43) Veröffentlichungstag der Anmeldung:
**02.11.2016 Patentblatt 2016/44**

(73) Patentinhaber: **ROBERT BOSCH GMBH**
**70442 Stuttgart (DE)**

(72) Erfinder: **Junger, Dieter**
**70374 Stuttgart (DE)**

(56) Entgegenhaltungen:
**EP-A1- 0 065 511**     **EP-A1- 1 530 037**
**EP-A1- 2 036 620**     **EP-A1- 2 216 539**
**EP-A1- 3 056 724**     **DE-A1- 10 315 425**
**DE-A1-102004 002 133**     **DE-A1-102011 078 908**
**GB-A- 1 243 546**

EP 3 088 723 B1

**Beschreibung**

Stand der Technik

Die Erfindung betrifft einen Kraftstoffinjektor, insbesondere einen Common-Rail-Injektor, nach dem Oberbegriff des Anspruchs 1.

Aus der nachveröffentlichten DE 10 2014 209 330 A1 der Anmelderin ist ein Kraftstoffinjektor bekannt, der im Bereich des Haltekörpers seines Injektorgehäuses eine Messeinrichtung aufweist, die dazu dient, zumindest indirekt die Stellung eines als Düsennadel ausgebildeten Einspritzglieds zu erfassen. Dadurch soll, insbesondere über die Lebens- bzw. Betriebsdauer des Kraftstoffinjektors betrachtet, trotz Verschleiß oder sonstigen Umständen eine stets optimale Anpassung der Steuerung der Bewegung des Einspritzglieds erzielt werden, damit eine mit einem derartigen Kraftstoffinjektor ausgestattete Brennkraftmaschine beispielsweise stets optimale Abgaswerte erreichen kann. Hierzu ist es bei dem bekannten Kraftstoffinjektor vorgesehen, dass ein als Piezoelement ausgebildetes Sensorelement mit der Oberfläche des Injektorgehäuses verklebt ist. Der Anbauort des Piezoelements befindet sich in unmittelbarer Umgebung einer einen Hochdruckraum des Kraftstoffinjektors mit unter Hochdruck stehendem Kraftstoff versorgenden Zulaufbohrung, in deren Bereich die Wanddicke des Injektorgehäuses reduziert ist. Dadurch wird am Anbauort des Piezoelements ein Verformungsbereich am Injektorgehäuse ausgebildet, der sich umso mehr elastisch nach außen wölbt, je größer der Kraftstoffdruck in der Zulaufbohrung ist. Durch das im Bereich des Verformungsbereichs aufgeklebte Piezoelement werden in Abhängigkeit von der Verformung Spannungssignale erzeugt, die mittels einer Auswerteschaltung ausgewertet werden können, um damit auf den Kraftstoffdruck in der Zulaufbohrung und dadurch die Stellung der Düsennadel zu schließen. Einzelheiten bezüglich der Ausbildung des Piezoelements, insbesondere hinsichtlich der Anordnung der beiden Elektrodenschichten des Piezoelements und deren elektrischer Kontaktierung, sind der erwähnten Schrift nicht zu entnehmen.

EP 3056724 A1, nicht vorveröffentlicht, offenbart einen Kraftstoffinjektor mit einem Drucksensor bei dem Piezoelemente, Elektroden und Isolationsschichten eine im Sinterverfahren hergestellte Baugruppe bilden.

EP 1530037 A1 offenbart einen weiteren Kraftstoffinjektor mit einem Drucksensor.

Offenbarung der Erfindung

Ausgehend von dem dargestellten Stand der Technik liegt der Erfindung die Aufgabe zugrunde, einen Kraftstoffinjektor nach dem Oberbegriff des Anspruchs 1 derart weiterzubilden, dass dessen Messeinrichtung unter Verwendung des Piezoelements herstellungstechnisch besonders einfach und vorteilhaft ausgebildet ist. Weiterhin soll es ermöglicht werden, das Piezoelement bereits während der Fertigung, insbesondere, bevor dieses in ein Gehäuse der Messeinrichtung eingesetzt wird, hinsichtlich seiner Funktion überprüfen zu können.

Diese Aufgabe wird erfindungsgemäß bei einem Kraftstoffinjektor mit den kennzeichnenden Merkmalen des Anspruchs 1 dadurch gelöst, dass das Piezoelement zwei Elektrodenschichten mit dazwischen angeordneter Piezokeramikschicht aufweist, dass die Elektrodenschichten auf der der Piezokeramikschicht abgewandten Seite mit jeweils einer Isolationsschicht überdeckt sind, und dass das Piezoelement zusammen mit den Isolationsschichten als eine im Sinterverfahren ausgebildete Baugruppe ist.

Es wird somit erfindungsgemäß insbesondere durch die Herstellbarkeit als Sinterbaugruppe eine relativ einfache Fertigung bzw. Verbindung der zwei Elektrodenschichten mit der dazwischenliegenden Piezokeramikschicht und Isolationsschichten ermöglicht, wobei dadurch, dass die Elektrodenschichten auf der der Piezokeramikschicht abgewandten Seite mit jeweils einer Isolationsschicht verbunden sind, insbesondere keine zusätzliche bzw. separate, elektrisch isolierende Schicht in Richtung des Injektorgehäuses des Kraftstoffinjektors benötigt wird.

Erfindungsgemäß ist es weiter zur Ausbildung einer besonders kompakt bauenden Messeinrichtung und einer einfachen Montage vorgesehen, dass die Baugruppe einen runden, kreissegmentförmigen oder rechteckförmigen Querschnitt aufweist, dass die beiden Elektrodenschichten jeweils mit einer Anschlussleitung verbunden sind, und dass die Anschlussleitungen innerhalb des Querschnitts der Baugruppe angeordnet sind. Das letztgenannte Merkmal ermöglicht insbesondere einen besonders kompakten Aufbau der Baugruppe, da die elektrische Kontaktierung der Elektrodenschichten nicht in einem radialen Randbereich der Elektrodenschichten mit einem entsprechenden, den radialen Bauraum durch die Anschlussleitungen vergrößernden Querschnitt erfolgen muss.

Vorteilhafte Weiterbildungen des erfindungsgemäßen Kraftstoffinjektors sind in den Unteransprüchen aufgeführt. In den Rahmen der Erfindung fallen sämtliche Kombinationen aus zumindest zwei von in den Ansprüchen, der Beschreibung und/oder den Figuren offenbarten Merkmalen.

Aufgrund der einfachen Herstellbarkeit und guter Isolationswirkungen ist es von Vorteil, wenn die Isolationsschichten aus unpolarisierten Piezokeramiken bestehen und auf ihren einander abgewandten Seiten zur Erzielung geringer Rauigkeiten und hoher Parallelität vorzugsweise durch einen Schleifprozeß bearbeitet sind. Durch das letztgenannte Merkmal wird eine hohe geometrische Genauigkeit der Baugruppe erzielt.

In bevorzugter konstruktiver Ausgestaltung des Gehäuses der Messeinrichtung ist es vorgesehen, dass das Gehäuse deckel- bzw. haubenförmig ausgebildet ist und eine Aufnahme für die Baugruppe aufweist, wobei eine Isolationsschicht an einem Bodenabschnitt des Gehäuses vorzugsweise vollflächig anliegt, und wobei die Tiefe der Aufnahme maximal der Dicke der Baugruppe entspricht. Eine derartige Ausbildung ermöglicht insbesondere einen besonders kompakten Aufbau der Messeinrichtung, da das Gehäuse für die Aufnahme der Baugruppe optimiert ist und über das Gehäuse eine Vorspannkraft auf das Piezoelement in Richtung des Injektorgehäuses erzeugbar ist.

Ein derartiges deckel- bzw. haubenförmiges Gehäuse besteht in einer weiteren bevorzugten Ausgestaltung der Erfindung aus einem Material mit einem geringen Wärmeausdehnungskoeffizienten, vorzugsweise aus Invar®. Eine derartige Ausbildung ermöglicht es, dass sich die Wärmeausdehnungskoeffizienten nahezu ausgleichen und somit über einen weiten Temperaturbereich des Kraftstoffinjektors die in dem Piezoelement erzeugten elektrischen Spannungen unabhängig von Eigenspannungen der Isolationsschichten bzw. des Gehäuses sind.

Aus Gründen einer möglichst einfachen Montage, der Vermeidung von mechanischen Spannungen sowie elektrischer Kurzschlüsse zwischen dem Messelement und dem Gehäuse ist es darüber hinaus von Vorteil, wenn die Baugruppe mit radialem Spiel in der Aufnahme des Gehäuses aufgenommen ist, und wenn zumindest die Elektrodenschichten auf der dem Gehäuse zugewandten Seite eine Isolierung aufweisen.

In konkreter konstruktiver Fortbildung des zuletzt angeführten Vorschlags ist es vorgesehen, die Baugruppe zur Führung der Anschlussleitungen und zur Ausbildung von Verbindungen mit den Elektrodenschichten sacklochförmige, vorzugsweise durch einen Laserbearbeitungsprozess ausgebildete Bohrungen aufweist, wobei die Bohrungen die jeweilige Elektrodenschicht vollständig durchdringen und bis in die in Richtung des Injektorgehäuses zugewandte Isolationsschicht hineinragen. Das letztgenannte Merkmal ermöglicht es, dass die Anschlussleitungen für die Elektrodenschichten von beiden Seiten der Elektrodenschichten mit der jeweiligen Elektrodenschicht verbindbar sind, so dass eine mechanisch und elektrisch besonders robuste und gute Verbindung ausgebildet werden kann. Dabei ist es insbesondere vorgesehen, dass die Verbindung zwischen den Elektrodenschichten und den Anschlussleitungen als Lötverbindungen ausgebildet sind.

Eine mit Blick auf die elektrische Verbindung der Messeinrichtung besonders robuste bzw. stabile Anordnung der Anschlussleitungen der Messeinrichtung wird erzielt, wenn die Anschlussleitungen im Bereich der Einführung in das Gehäuse einen vergrößerten Durchmesser bzw. Querschnitt aufweisen. Eine derartige Anschlussleitung weist eine relativ hohe mechanische Festigkeit auf, die beispielsweise bei auftretenden Vibrationen, Temperaturwechseln usw. besonders vorteilhaft ist. Der Durchmesser der Anschlussleitungen bzw. -drähte ist demgegenüber im Bereich des Sensorelements bzw. der Sacklochbohrungen reduziert. Darüber hinaus ist es bevorzugt vorgesehen, wenn im Bereich der Durchführung der Anschlussleitungen in dem Gehäuse der Durchmesser bzw. Querschnitt der Durchgangsöffnungen im Gehäuse derart vergrößert ausgebildet ist, dass trotz des im Bereich der Durchgangsöffnungen vorgesehenen größeren Durchmessers bzw. Querschnitts der Anschlussleitungen die Verwendung einer Glasumschmelzung zum diffusionsdichten Ausfüllen des Radialspalts zwischen den Anschlussleitungen und den Durchgangsöffnungen ermöglicht wird.

Eine weitere bevorzugte Ausführungsform der Erfindung sieht vor, dass die der jeweiligen Elektrodenschicht zugewandten Enden der Anschlussleitungen in einem Abstand zum Grund der (sacklochförmigen) Bohrung der Baugruppe enden. Dadurch wird ein axialer Abstand ausgebildet, der von dem Lot der Lötverbindung ausgefüllt wird und dadurch eine besonders sichere bzw. zuverlässige Lötverbindung ausbildet. Auch werden Längenunterschiede der freien Drahtenden der Anschlussleitungen nach dem Glasumschmelzen ausgeglichen.

Um der Montage der Anschlussleitungen eine eindeutige, verpolsichere Zuordnung der Anschlussleitungen zu den Elektrodenschichten zu erzielen, ist es darüber hinaus vorgesehen, dass die Bohrungen unsymmetrisch zu einer Symmetrieachse der Baugruppe angeordnet sind.

Weiterhin ist es in Verbindung mit dem Gehäuse bevorzugt vorgesehen, dass das Gehäuse fluchtend zu den Bohrungen Durchgangsöffnungen zur Durchführung der Anschlussleitungen aufweist, und dass die Zwischenräume zwischen den Anschlussleitungen und den Durchgangsöffnungen mit einer Isolationsmasse ausgefüllt sind. Dadurch wird insbesondere der Zutritt von die Funktion der Messeinrichtung beeinträchtigenden Medien, wie Flüssigkeiten, Dämpfen oder ähnliches in den Innenraum des Gehäuses vermieden.

Weitere Vorteile, Merkmale und Einzelheiten der Erfindung ergeben sich aus der nachfolgenden Beschreibung bevorzugter Ausführungsbeispiele sowie anhand der Zeichnung.

Diese zeigt in:

Fig. 1      eine stark vereinfachte, teilweise geschnittene Seitenansicht eines erfindungsgemäßen Kraftstoffinjektors mit einer Messeinrichtung zur zumindest mittelbaren Erfassung des Kraftstoffdrucks im Kraftstoffinjektor,

Fig. 2      einen Längsschnitt durch eine erste Ausführungsform der Messeinrichtung ,

Fig. 3 bis Fig. 5    jeweils Querschnitte im Bereich einer Messeinrichtung gemäß Fig. 2 bei unterschiedlich ausgebildeten Querschnitten der verwendeten Piezoelementen bzw. des Gehäuses und

Fig. 6    einen Längsschnitt durch eine zweite Ausführungsform der Messeinrichtung.

Gleiche Elemente bzw. Elemente mit gleicher Funktion sind in den Figuren mit den gleichen Bezugsziffern versehen.

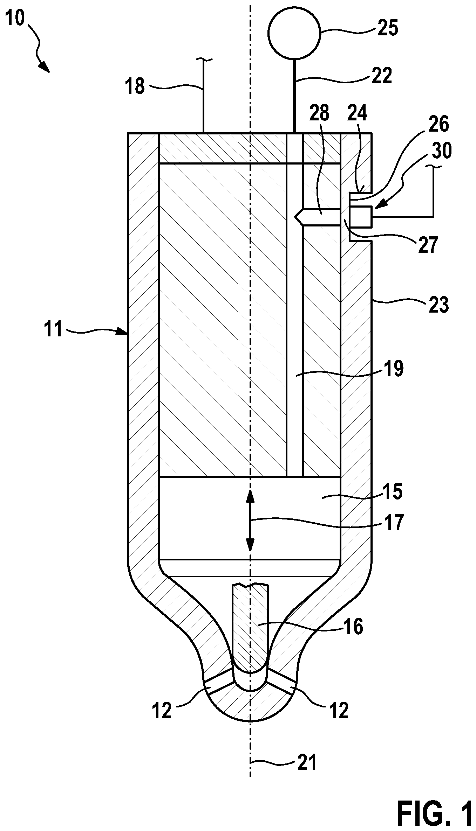

Der in der Fig. 1 stark vereinfacht dargestellte Kraftstoffinjektor 10 ist als sogenannter Common-Rail-Injektor ausgebildet, und dient dem Einspritzen von Kraftstoff in den nicht gezeigten Brennraum einer Brennkraftmaschine, insbesondere einer selbstzündenden Brennkraftmaschine.

Der Kraftstoffinjektor 10 weist ein im Wesentlichen aus Metall bestehendes, ggf. mehrteilig ausgebildetes Injektorgehäuse 11 auf, in dem auf der dem Brennraum der Brennkraftmaschine zugewandten Seite wenigstens eine, vorzugsweise mehrere Einspritzöffnungen 12 zum Einspritzen des Kraftstoffs in den Brennraum angeordnet sind. Innerhalb des Injektorgehäuses 11 weist dieses einen Hochruckraum 15 auf, in dem eine als Einspritzglied dienende Düsennadel 16 in Richtung des Doppelpfeils 17 hubbeweglich angeordnet ist. In der dargestellten, abgesenkten Stellung der Düsennadel 16 bildet diese zusammen mit der Innenwand des Hochdruckraums 15 bzw. des Injektorgehäuses 11 einen Dichtsitz aus, so dass die Einspritzöffnungen 12 zumindest mittelbar verschlossen sind, derart, dass ein Einspritzen von Kraftstoff aus dem Hochdruckraum 15 in den Brennraum der Brennkraftmaschine verhindert wird. In der anderen, nicht dargestellten, von dem Dichtsitz abgehobenen Position der Düsennadel 16 gibt diese die Einspritzöffnungen 12 zum Einspritzen des Kraftstoffs in den Brennraum der Brennkraftmaschine frei.

Die Bewegung der Düsennadel 16, insbesondere zum Freigeben der Einspritzöffnungen 12, erfolgt auf eine an sich bekannte Art und Weise mittels eines nicht dargestellten Aktuators, der über eine Spannungsversorgungsleitung 18 von einer Steuereinrichtung der Brennkraftmaschine ansteuerbar ist. Bei dem Aktuator kann es sich beispielsweise um einen Magnetaktuator oder um einen Piezoaktuator handeln.

Die Versorgung des Hochdruckraums 15 mit unter Hochdruck (Systemdruck) stehendem Kraftstoff erfolgt über eine innerhalb des Injektorgehäuses 11 angeordnete bzw. in Bauteilen des Kraftstoffinjektors 10 ausgebildete Versorgungsbohrung 19, die insbesondere exzentrisch zur Längsachse 21 des Injektorgehäuses 11 in einem Randbereich des Kraftstoffinjektors 10, zumindest im Wesentlichen parallel zur Längsachse 21, verläuft. Die Versorgungsbohrung 19 ist darüber hinaus über einen nicht dargestellten Kraftstoffanschlussstutzen mit einer Kraftstoffleitung 22 verbunden, welche wiederum mit einem Kraftstoffspeicher 25 (Rail) gekoppelt ist.

In einem von den Einspritzöffnungen 12 bzw. dem Brennraum axial relativ weit beabstandeten Bereich des Injektorgehäuses 11 ist in dessen Außenwand 23 beispielhaft eine sacklochförmige Vertiefung 24 ausgebildet, so dass die Wanddicke des Injektorgehäuses 11 im Bereich der Vertiefung 24 reduziert ist. Ergänzend wird erwähnt, dass anstelle einer sacklochförmigen Vertiefung 24 das Injektorgehäuse 11 auch eine Abflachung aufweisen kann, in deren Bereich die Wanddicke des Injektorgehäuses 11 reduziert ist.

Der eben ausgebildete Grund 26 der Vertiefung 24 bildet einen Teil eines Verformungsbereichs 27 aus. Auf der der Vertiefung 24 abgewandten Seite des Injektorgehäuses 11 ist der Verformungsbereich 27 in Wirkverbindung mit einem Abzweig 28 angeordnet, der wiederum in der Versorgungsbohrung 19 mündet. Dadurch wirkt der in der Versorgungsbohrung 19 herrschende Kraftstoffdruck auch auf der der Vertiefung 24 abgewandten Seite des Verformungsbereichs 27. Da die Wanddicke des Injektorgehäuses 11 im Bereich der Vertiefung 24 reduziert ist, wirkt der Verformungsbereich 27 des Injektorgehäuses 11 auf der der Vertiefung 24 zugewandten Seite in Art einer elastisch verformbaren Membran, wobei die Verformung, welche sich als Wölbung ausbildet, umso größer ist, je höher der Kraftstoffdruck in der Versorgungsbohrung 19 bzw. dem Abzweig 28 ist.

Zur Detektion des zeitlichen Verlaufs des Kraftstoffdrucks in dem Abzweig 28 bzw. in der Versorgungsbohrung 19 und damit auch in dem Hochdruckraum 15, welcher als Indiz für die augenblickliche Stellung der Düsennadel 16 zur Ansteuerung der Düsennadel 16 verwendet wird, weist der Kraftstoffinjektor 10 eine Messeinrichtung 30 auf.

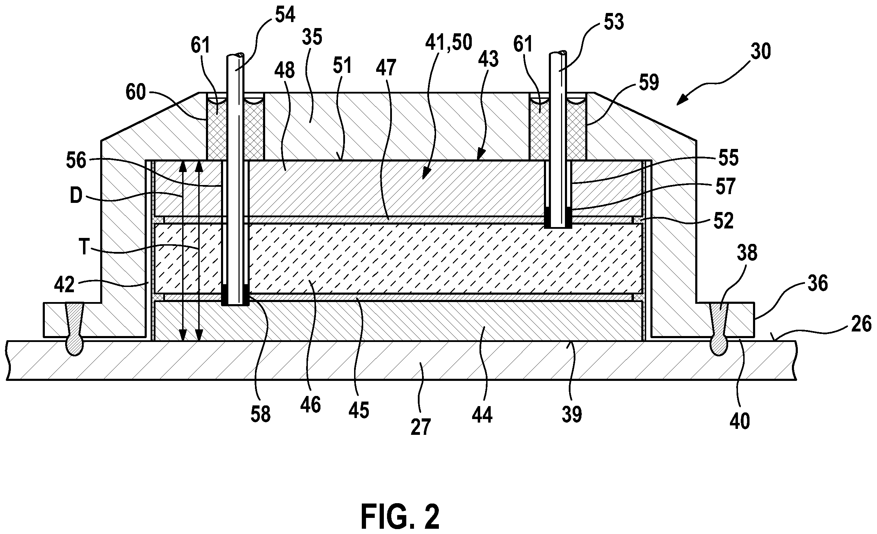

Die Messeinrichtung 30 hat entsprechend der Darstellung der Fig. 2 ein vorzugsweise aus Metall, insbesondere aus Invar ® bestehendes, im Tiefziehverfahren hergestelltes Gehäuse 35. Das deckel- bzw. haubenförmige Gehäuse 35 hat einen umlaufenden Flansch 36, in dessen Bereich eine insbesondere als Laserschweißverbindung ausgebildete Schweißnaht 38 dazu dient, das Gehäuse 35 der Messeinrichtung 30 mit dem Injektorgehäuse 11 im Bereich der Vertiefung 24 zu verbinden. Dabei ist zwischen dem Grund 26 der Vertiefung 24 und der zugewandten Fläche des Flansches 36 ggf. ein Schweißspalt 40 ausgebildet.

Weiterhin umfasst die Messeinrichtung 30 ein als Piezoelement 41 ausgebildetes Sensorelement. Das Piezoelement 41 ist unter Ausbildung eines Radialspalts 42 in einer Aufnahme 43 des Gehäuses 35 aufgenommen. Das Piezoelement 41 weist eine erste Isolationsschicht 44, eine erste Elektrodenschicht 45, eine Piezokeramikschicht 46, eine zweite Elektrodenschicht 47 und eine zweite Isolationsschicht 48 auf. Die soweit beschriebenen Schichten 44 bis 48 sind sandwichartig übereinander und in Kontakt miteinander angeordnet, wobei die Piezokeramikschicht 46 zwischen den beiden Elektrodenschichten 45 und 47 angeordnet ist, und wobei die beiden Isolationsschichten 44, 48 auf der der jeweiligen Elektrodenschicht 45, 47 abgewandten Seite der Piezokeramikschicht 46 angeordnet sind.

Die beiden Isolationsschichten 44, 48 bestehen vorzugsweise aus unpolarisierten Piezokeramiken (alternativ auch aus Aluminiumoxid). Hinsichtlich der Dimensionierung bzw. der Schichtdicken der Piezokeramikschicht 46 und der beiden Isolationsschichten 44, 48 wird wie folgt vorgegangen: Zuerst wird anhand von Versuchsreihen oder Berechnungen die benötigte Schichtdichte der Piezokeramikschicht 46 zur Erzeugung des gewünschten Nutzsignals ermittelt. Anschließend lässt sich die Schichtdicke der beiden Isolationsschichten 44, 48 (für den Fall, dass diese gleich dick sind) wie folgt ermitteln:

$$I = P \times (\alpha T - \alpha P) / (2 \times (\alpha I - \alpha T)),$$

wobei

I die Schichtdicke der Isolationsschicht 44, 48,
P die Schichtdicke der Piezokeramikschicht 46
$\alpha$T der Wärmeausdehnungskoeffizient des Gehäuses 35 in dem axialen Teilbereich des Gehäuses 35, in dem sich das Piezoelement 41 befindet,
aP der Wärmeausdehnungskoeffizient der Piezokeramikschicht 46 und
al der Wärmeausdehnungskoeffizient der der Isolationsschicht 44, 48 bedeuten.

Die Schichten 44 bis 48 bilden bei entsprechender Materialauswahl eine im Sinterverfahren herstellbare Baugruppe 50 aus. Die Baugruppe 50 ist im Bereich der beiden Isolationsschichten 44, 48 sind auf ihren einander abgewandten Seiten zur Erzielung geringer Rauigkeiten und ebener Flächen, vorzugsweise durch Schleifen, bearbeitet. Insbesondere liegt die erste Isolationsschicht 44 vorzugsweise vollflächig am Grund 39 der Vertiefung 24 an, während die zweite Isolationsschicht 48 vorzugsweise vollflächig an einem Boden 51 der Aufnahme 43 anliegt. Die Dicke D der Baugruppe 50 entspricht der Tiefe T der Aufnahme 43, ggf. unter zusätzlicher Berücksichtigung der Höhe des Schweißspalts 40.

Der Außenumfang der Baugruppe 50 ist im Bereich der beiden Elektrodenschichten 45, 47 mit einer Isolierung 52, z.B. in Form eines Isolationslacks, versehen. Zusätzlich ist in der Fig. 2 der Fall dargestellt, dass die beiden Elektrodenschichten 45, 47 radial nicht bis an den (radialen) Rand der beiden Isolationsschichten 44, 48 sowie die Piezokeramikschicht 46 heranreichen.

Zur elektrischen Kontaktierung der Baugruppe 50 dienen zwei elektrische Anschlussleitungen 53, 54. Weiterhin sind in der Baugruppe 50 zwei sacklochförmige, vorzugsweise durch eine Laserstrahlbearbeitung hergestellte Bohrungen 55, 56 ausgebildet. Die beiden Bohrungen 55, 56 durchdringen jeweils die zweite Isolationsschicht 48, wobei die Bohrung 56 die Piezokeramikschicht 46 vollständig durchdringt und bis in die erste Isolationsschicht 44 hineinragt, während die Bohrung 55 (lediglich) bis in die Piezokeramikschicht 45 hineinragt. Mit anderen Worten gesagt bedeutet dies, dass die beiden Bohrungen 55, 56 die beiden Elektrodenschichten 45, 47 vollständig durchdringen und in Richtung des Injektorgehäuses 11 weitergeführt sind.

Die beiden Anschlussleitungen 53, 54 sind insbesondere in Form eines Lackdrahts ausgebildet, der mit geringem radialen Spalt innerhalb der Bohrung 55, 56 angeordnet ist. Im Bereich der beiden Elektrodenschichten 45, 47 ist der jeweilige Endbereich der Anschlussleitung 53, 54 von dem Lack befreit und mittels einer Lötverbindung 57, 58 mit der jeweiligen Elektrodenschicht 45, 47 verbunden. Die Ausbildung der Lötverbindung 57, 58 erfolgt vorzugsweise dadurch, dass nach dem Ausbilden der beiden Bohrungen 55, 56 Lot in den Bereich der jeweiligen Elektrodenschicht 45, 47 eingebracht wird, welches im flüssigen Zustand in Wirkverbindung mit den in die Bohrung 55, 56 eingeführten Enden der beiden Anschlussleitungen 53, 54 gelangt. Nach dem Erstarren des Lotes sind die Anschlussleitungen 53, 54 fest mit der jeweiligen Elektrodenschicht 45, 47 verbunden. Die Baugruppe 50 ist bei montierten Anschlussleitungen 53, 54 vor der Montage in dem Gehäuse 35 hinsichtlich seiner Funktion überprüfbar.

Um die Anschlussleitungen 53, 54 aus dem Gehäuse 35 herauszuführen, weist das Gehäuse 35, fluchtend zu den Bohrungen 55, 56, Durchgangsöffnungen 59, 60 auf. Der radiale Zwischenraum zwischen den Anschlussleitungen 53, 54 und den Durchgangsöffnungen 59, 60 des Gehäuses 35 ist mit einer Dichtungs- bzw. Isolationsmasse 61 ausgefüllt.

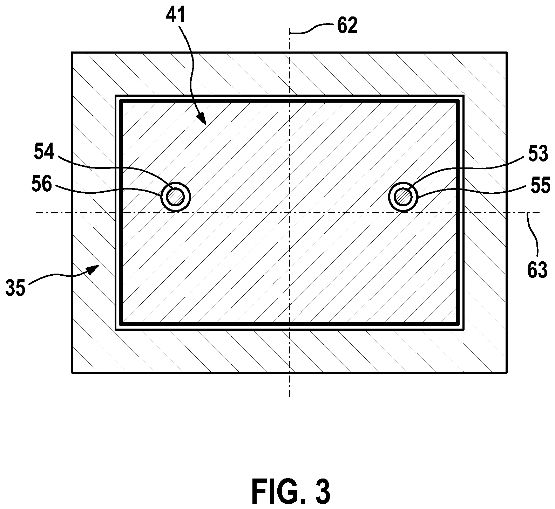

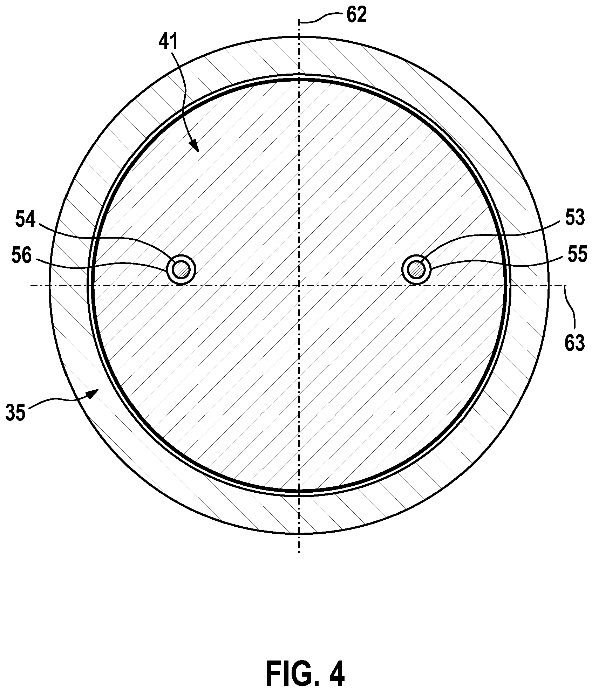

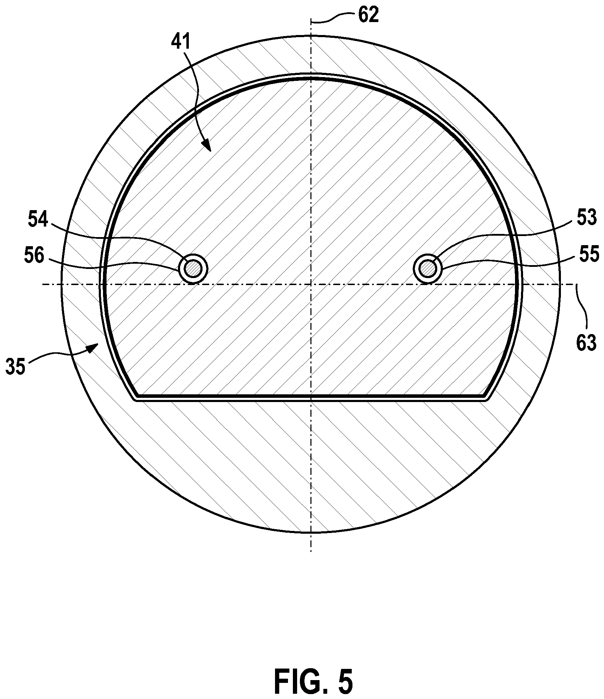

Der Querschnitt des Piezoelements 41 sowie vorzugsweise auch des Gehäuses 35 ist entsprechend der Darstellung der Fig. 3 bis 5 vorzugsweise rechteckförmig (Fig. 3), kreisförmig (Fig. 4) oder kreissegmentförmig (Fig. 5) ausgebildet. Wesentlich ist, dass die Anordnung der Bohrungen 55, 56 beispielhaft symmetrisch zu einer ersten Symmetrieachse 62, jedoch außerhalb bzw. unsymmetrisch zu einer zweiten Symmetrieachse 63 angeordnet sind.

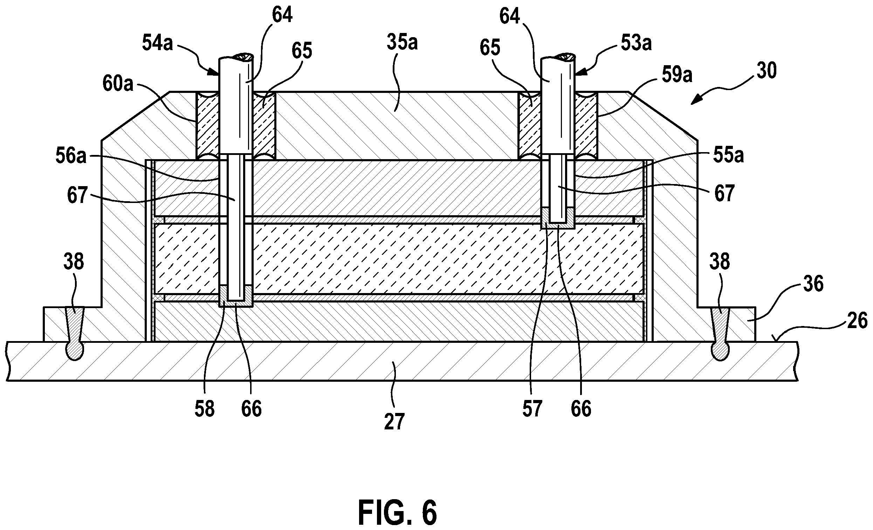

In der Fig. 6 ist eine abgewandelte Ausführungsform der Messeinrichtung 30 dargestellt. Diese unterscheidet sich von der Ausführungsform der Fig. 2 insbesondere durch die Verwendung eines Gehäuses 35a aus, dessen Durchgangsöffnungen 59a, 60a im Verhältnis zu den Durchgangsöffnungen 59, 60 beim Gehäuse 35 einen vergrößerten Durchmesser bzw. Querschnitt auf. Dieser dient dazu, Anschlussleitungen 53a, 54a mit genügend großem Radialspiel aufzunehmen, deren Anschlussdrähte 67 im Bereich der Durchgangsöffnungen 59a, 60a einem Abschnitt 64 mit vergrößertem Durchmesser bzw. Querschnitt aufweisen. Im Bereich der Bohrungen 55a, 56a ist der Durchmesser der Anschlußdrähte 67 demgegenüber (im Vergleich zum Abschnitt 64) reduziert. Darüber hinaus wird es durch die Vergrößerung der Durchgangsöffnungen 59a, 60a insbesondere ermöglicht, trotz der Verwendung der im Durchmesser bzw. Querschnitt vergrößerten Anschlußdrähte 67 einen derart großen Radialspalt auszubilden, dass die Verwendung einer Glasverschmelzung 65 als Isolationsmasse 61 ermöglicht wird. Eine derartige Glasverschmelzung 65 stellt eine diffusionsdichte Abdichtung des Gehäuses 35a sicher. Zuletzt ist erkennbar, dass die der jeweiligen Elektrodenschicht 45, 47 zugewandten Enden der Anschlussleitungen 53a, 54a oberhalb des Grundes der jeweiligen Bohrung 55a, 56a enden, so dass zwischen den Anschlussdrähten 67 und dem Grund der Bohrung 55a, 56a ein Abstand 66 ausgebildet ist, der von dem Lot der Lötverbindung 57, 58 ausgefüllt ist, und dadurch Längenunterschiede des freien Drahtendes nach dem Glaseinschmelzen ausgleicht.

Der soweit beschriebene Kraftstoffinjektor 10 sowie das Piezoelement 41 können in vielfältiger Art und Weise abgewandelt bzw. modifiziert werden, ohne vom Erfindungsgedanken abzuweichen, wie in den beigefügten Ansprüchen definiert.

**Patentansprüche**

1. Kraftstoffinjektor (10), insbesondere Common-Rail-Injektor, mit einem Injektorgehäuse (11), in dem ein Hochdruckraum (15) ausgebildet ist, der über eine im Injektorgehäuse (11) angeordnete Versorgungsbohrung (19) mit unter Druck stehendem Kraftstoff versorgbar ist, mit wenigstens einer zumindest mittelbar mit dem Hochdruckraum (15) verbundenen, im Injektorgehäuse (11) ausgebildeten Einspritzöffnung (12) zum Einspritzen von Kraftstoff in den Brennraum einer Brennkraftmaschine, mit einem die wenigstens eine Einspritzöffnung (12) freigebenden oder verschließenden Einspritzglied (16), und mit einer Messeinrichtung (30) zur zumindest mittelbaren Erfassung des Drucks im Hochdruckraum (15) oder der Versorgungsbohrung (19), wobei die Messeinrichtung (30) dazu ausgebildet ist, eine elastische Verformung eines zumindest mittelbar mit der Versorgungsbohrung (19) oder dem Hochdruckraum (15) in Wirkverbindung angeordneten Verformungsbereichs (27) zu erfassen, und wobei die Messeinrichtung (30) ein Piezoelement (41) aufweist, das in einem mit dem Injektorgehäuse (11) verbundenen Gehäuse (35; 35a) aufgenommen ist, wobei das Piezoelement (41) zwei Elektrodenschichten (45, 47) mit dazwischen angeordneter Piezokeramikschicht (46) aufweist, dass die Elektrodenschichten (45, 47) auf der der Piezokeramikschicht (46) abgewandten Seite mit jeweils einer Isolationsschicht (46, 48) überdeckt sind, **dadurch gekennzeichnet dass** das Piezoelement (41) zusammen mit den Isolationsschichten (46, 48) eine im Sinterverfahren ausgebildete Baugruppe (50) ist, und dass die Baugruppe (50) einen runden, kreissegmentförmigen oder rechteckförmigen Querschnitt aufweist, dass die beiden Elektrodenschichten (45, 47) jeweils mit einer Anschlussleitung (53; 53a, 54; 54a) verbunden sind und dass die Anschlussleitungen (53; 53a, 54; 54a) innerhalb des Querschnitts der Baugruppe (50) angeordnet sind.

2. Kraftstoffinjektor nach Anspruch 1,
   **dadurch gekennzeichnet,**
   **dass** die Isolationsschichten (46, 48) aus unpolarisierten Piezokeramiken bestehen und auf ihren einander abgewandten Seiten zur Erzielung geringer Rauigkeiten und hoher Parallelität vorzugsweise durch einen Schleifprozess bearbeitet sind.

3. Kraftstoffinjektor nach Anspruch 2,
   **dadurch gekennzeichnet,**
   **dass** sich die Schichtdicke der Isolationsschicht (44, 48) wie folgt ermittelt:

$$I = P \times (\alpha T - \alpha P) / (2 \times (\alpha I - \alpha T)),$$

wobei

I die Schichtdicke der Isolationsschicht (44, 48),
P die Schichtdicke der Piezokeramikschicht (46),
$\alpha T$ der Wärmeausdehnungskoeffizient des Gehäuses (35) in dem axialen Teilbereich des Gehäuses (35), in dem sich das Piezoelement (41) befindet, aP der Wärmeausdehnungskoeffizient der Piezokeramikschicht (46) und αl der Wärmeausdehnungskoeffizient der der Isolationsschicht (44, 48) bedeuten.

4.  Kraftstoffinjektor nach einem der Ansprüche 1 bis 3,
    **dadurch gekennzeichnet,**
    **dass** das Gehäuse (35; 35a) haubenförmig ausgebildet ist und eine Aufnahme (43) für die Baugruppe (50) aufweist, wobei eine Isolationsschicht (48) an einem Boden (51) des Gehäuses (35; 35a) zumindest bereichsweise anliegt, und wobei die Tiefe (T) der Aufnahme (43) maximal der Dicke (D) der Baugruppe (50) entspricht.

5.  Kraftstoffinjektor nach Anspruch 4,
    **dadurch gekennzeichnet,**
    **dass** das Piezoelement (41) mit seiner dem Boden (51) zugewandten Isolationsschicht (48) vollflächig an dem Boden (51) anliegt.

6.  Kraftstoffinjektor nach Anspruch 4 oder 5,
    **dadurch gekennzeichnet,**
    **dass** das Gehäuse (35) einen umlaufenden Flansch (36) aufweist, der über eine Schweißverbindung (38) mit dem Injektorgehäuse (11) verbunden ist, und dass die Tiefe (T) der Aufnahme (43) um einen Schweißspalt (40) geringer ist als die Dicke (D) der Baueinheit (50).

7.  Kraftstoffinjektor nach einem der Ansprüche 1 bis 6,
    **dadurch gekennzeichnet,**
    **dass** das Gehäuse (35; 35a) aus einem Material mit geringem Wärmeausdehnungskoeffizienten, vorzugsweise aus Invar ®, besteht.

8.  Kraftstoffinjektor nach einem der Ansprüche 1 bis 7,
    **dadurch gekennzeichnet,**
    **dass** die Baugruppe (50) mit radialem Spiel in dem Gehäuse (35; 35a) aufgenommen ist, und dass zumindest die Elektrodenschichten (45, 47) auf der dem Gehäuse (35; 35a) zugewandten Seite eine Isolierung (52) aufweisen.

9.  Kraftstoffinjektor nach Anspruch 7 oder 8,
    **dadurch gekennzeichnet,**
    **dass** die Baugruppe (50) zur Führung der Anschlussleitungen (53; 53a, 54; 54a) und zur Ausbildung von Verbindungen (57, 58) mit den Elektrodenschichten (45, 47) sacklochförmige, vorzugsweise durch einen Laserbearbeitungsprozess ausgebildete Bohrungen (55; 55a, 56; 56a) aufweist, wobei die Bohrungen (55; 55a, 56; 56a) die jeweilige Elektrodenschicht (45, 47) vollständig durchdringen und bis in die in Richtung des Injektorgehäuses (11) zugewandte Isolationsschicht (44, 48) hineinragen.

10. Kraftstoffinjektor nach Anspruch 9,
    **dadurch gekennzeichnet,**
    **dass** das Gehäuse (35; 35a) fluchtend zu den Bohrungen (55; 55a, 56; 56a) Durchgangsöffnungen (59; 59a, 60; 60a) zur Durchführung der Anschlussleitungen (53; 53a, 54; 54a) aufweist, und dass der Zwischenraum zwischen den Anschlussleitungen (53; 53a, 54; 54a) und den Durchgangsöffnungen (59; 59a, 60; 60a) mit einer Isolationsmasse (61) ausgefüllt sind.

11. Kraftstoffinjektor nach Anspruch 10,
    **dadurch gekennzeichnet,**
    **dass** die Anschlussleitungen (53a, 54a) im Bereich der Durchgangsöffnungen (59a, 60a) einen Anschlussdraht (67) mit einem Abschnitt (64) aufweisen, der im Durchmesser vergrößert ausgebildet ist, dass der Durchmesser des Anschlussdrahts (67) im Bereich der Bohrungen (55a,56a) reduziert ist, dass der Querschnitt der Durchgangsöffnungen (59a, 60a) größer ist als der Querschnitt der Bohrungen (55a,56a), und dass die Isolationsmasse (61) vorzugsweise in Form einer Glasverschmelzung (65) ausgebildet ist.

12. Kraftstoffinjektor nach einem der Ansprüche 9 bis 11,
    **dadurch gekennzeichnet,**
    **dass** die Verbindungen (57, 58) als Lötverbindungen ausgebildet sind.

13. Kraftstoffinjektor nach Anspruch 12,

**dadurch gekennzeichnet,**

**dass** zwischen den Anschlussleitungen (53a, 54a) auf der der jeweiligen Elektrodenschicht (45, 47) zugewandten Seite und dem Grund der jeweiligen Bohrung (55a, 56a) ein Abstand (66) ausgebildet ist, der von Lot ausgefüllt ist.

14. Kraftstoffinjektor nach einem der Ansprüche 9 bis 13,
**dadurch gekennzeichnet,**
**dass** die Bohrungen (55; 55a, 56; 56a) unsymmetrisch zu einer Symmetrieachse (63) der Baugruppe (50) angeordnet sind.

**Claims**

1. Fuel injector (10), in particular common rail injector, comprising an injector housing (11), in which a high-pressure chamber (15) is formed, which can be supplied with fuel under pressure via a supply port (19) arranged in the injector housing (11), comprising at least one injection opening (12), connected at least indirectly to the high-pressure chamber (15) and formed in the injector housing (11), for injecting fuel into the combustion chamber of an internal combustion engine, comprising an injection element (16) opening or closing the at least one injection opening (12), and comprising a measuring device (30) for the at least indirect detection of the pressure in the high-pressure chamber (15) or the supply port (19), the measuring device (30) being designed to detect elastic deformation of a deformation region (27) arranged in operative connection at least indirectly with the supply port (19) or the high-pressure chamber (15), and the measuring device (30) having a piezoelectric element (41), which is accommodated in a housing (35; 35a) connected to the injector housing (11), the piezoelectric element (41) having two electrode layers (45, 47) with a piezoceramic layer (46) arranged between them, in that the electrode layers (45, 47) on the side facing away from the piezoceramic layer (46) are each covered with an insulating layer (46, 48), **characterized in that** the piezoelectric element (41), together with the insulating layers (46, 48), is a subassembly (50) formed in the sintering process, and **in that** the subassembly (50) has a cross section that is round, shaped like a circular segment or rectangular, **in that** the two electrode layers (45, 47) are each connected to a connecting line (53; 53a, 54; 54a), and **in that** the connecting lines (53; 53a, 54; 54a) are arranged within the cross section of the subassembly (50).

2. Fuel injector according to Claim 1,
**characterized in that**
the insulating layers (46, 48) consist of unpolarized piezoceramics and, on their sides facing away from each other, are preferably machined by a grinding process to achieve low roughnesses and high parallelism.

3. Fuel injector according to Claim 2,
**characterized in that**
the layer thickness of the insulating layer (44, 48) is determined as follows:

$$I = P \times (\alpha T - \alpha P)/(2 \times (\alpha I - \alpha T)),$$

where

I means the layer thickness of the insulating layer (44, 48),
P means the layer thickness of the piezoceramic layer (46),
$\alpha T$ means the coefficient of thermal expansion of the housing (35) in the axial portion of the housing (35) in which the piezoelectric element (41) is located,
$\alpha P$ means the coefficient of thermal expansion of the piezoceramic layer (46), and
$\alpha I$ means the coefficient of thermal expansion of the of the insulating layer (44, 48).

4. Fuel injector according to one of Claims 1 to 3,
**characterized in that**
the housing (35; 35a) is formed in the shape of a hood and has a receptacle (43) for the subassembly (50), wherein an insulating layer (48) rests at least partly on a base (51) of the housing (35; 35a), and wherein the depth (T) of the receptacle (43) corresponds at most to the thickness (D) of the subassembly (50).

**5.** Fuel injector according to Claim 4,
**characterized in that**
the piezoelectric element (41) rests in a completely planar manner on the base (51) with its insulating layer (48) facing the base (51).

**6.** Fuel injector according to Claim 4 or 5,
**characterized in that**
the housing (35) has a circumferential flange (36), which is connected to the injector housing (11) via a welded connection (38), and **in that** the depth (T) of the receptacle (43) is lower by a welding gap (40) than the thickness (D) of the subassembly (50).

**7.** Fuel injector according to one of Claims 1 to 6,
**characterized in that**
the housing (35; 35a) consists of a material with a low coefficient of thermal expansion, preferably of Invar®.

**8.** Fuel injector according to one of Claims 1 to 7,
**characterized in that**
the subassembly (50) is accommodated in the housing (35; 35a) with radial play, and **in that** at least the electrode layers (45, 47) have insulation (52) on the side facing the housing (35; 35a).

**9.** Fuel injector according to Claim 7 or 8,
**characterized in that**
in order to guide the connecting lines (53; 53a, 54; 54a) and to form connections (57, 58) to the electrode layers (45, 47), the subassembly (50) has blind-hole-shaped bores (55; 55a, 56; 56a) preferably formed by a laser machining process, wherein the bores (55; 55a, 56; 56a) penetrate the respective electrode layer (45, 47) completely and project as far as into the insulating layer (44, 48) facing in the direction of the injector housing (11).

**10.** Fuel injector according to Claim 9,
**characterized in that**
the housing (35; 35a) has passage openings (59; 59a, 60; 60a) flush with the bores (55; 55a, 56; 56a) to lead the connecting lines (53; 53a, 54; 54a) through, and **in that** the intermediate space between the connecting lines (53; 53a, 54; 54a) and the passage openings (59; 59a, 60; 60a) is filled with an insulating compound (61).

**11.** Fuel injector according to Claim 10,
**characterized in that**
the connecting lines (53a, 54a) in the region of the passage openings (59a, 60a) have a connecting wire (67) with a section (64) which is formed with an enlarged diameter, **in that** the diameter of the connecting wire (67) in the region of the bores (55a, 56a) is reduced, **in that** the cross section of the passage openings (59a, 60a) is larger than the cross section of the bores (55a, 56a), and **in that** the insulating compound (61) is preferably formed in the form of a glass meld (65).

**12.** Fuel injector according to one of Claims 9 to 11,
**characterized in that**
the connections (57, 58) are formed as solder connections.

**13.** Fuel injector according to Claim 12,
**characterized in that**
between the connecting lines (53a, 54a) on the side facing the respective electrode layer (45, 47) and the base of the respective bore (55a, 56a) there is formed a space (66) which is filled with solder.

**14.** Fuel injector according to one of Claims 9 to 13,
**characterized in that**
the bores (55; 55a, 56; 56a) are arranged asymmetrically in relation to an axis of symmetry (63) of the subassembly (50).

**Revendications**

1.  Injecteur de carburant (10), en particulier injecteur à rampe commune, comprenant un boîtier d'injecteur (11) dans lequel est réalisé un espace haute pression (15) qui peut être alimenté en carburant sous pression par le biais d'un alésage d'alimentation (19) disposé dans le boîtier d'injecteur (11), au moins une ouverture d'injection (12) réalisée dans le boîtier d'injecteur (11), connectée au moins indirectement à l'espace haute pression (15), pour injecter du carburant dans la chambre de combustion d'un moteur à combustion interne, un organe d'injection (16) libérant ou fermant l'au moins une ouverture d'injection (12), et un dispositif de mesure (30) pour détecter au moins indirectement la pression dans l'espace haute pression (15) ou dans l'alésage d'alimentation (19), le dispositif de mesure (30) étant réalisé de manière à détecter une déformation élastique d'une zone de déformation (27) disposée en liaison fonctionnelle au moins indirectement avec l'alésage d'alimentation (19) ou avec l'espace haute pression (15), et le dispositif de mesure (30) présentant un élément piézoélectrique (41) qui est reçu dans un boîtier (35 ; 35a) connecté au boîtier d'injecteur (11), l'élément piézoélectrique (41) présentant deux couches d'électrodes (45, 47) avec une couche en piézocéramique (46) disposée entre elles, en ce que les couches d'électrodes (45, 47) sur le côté opposé à la couche en piézocéramique (46) sont à chaque fois revêtues d'une couche d'isolation (46, 48),
    **caractérisé en ce que**
    l'élément piézoélectrique (41), conjointement avec les couches d'isolation (46, 48), est un module (50) réalisé dans un procédé de frittage et le module (50) présente une section transversale ronde, en forme de segment de cercle ou rectangulaire, les deux couches d'électrodes (45, 47) sont à chaque fois connectées à une conduite de raccordement (53 ; 53a, 54 ; 54a) et les conduites de raccordement (53 ; 53a, 54 ; 54a) sont disposées à l'intérieur de la section transversale du module (50).

2.  Injecteur de carburant selon la revendication 1,
    **caractérisé en ce que**
    les couches d'isolation (46, 48) se composent de piézocéramiques non polarisées et sont de préférence traitées par un procédé de meulage sur leurs côtés mutuellement opposés pour obtenir de faibles rugosités et un grand parallélisme.

3.  Injecteur de carburant selon la revendication 2,
    **caractérisé en ce que**
    l'épaisseur de couche de la couche d'isolation (44, 48) est déterminée comme suit :

    $$I = P \times (\alpha T - \alpha P)/(2 \times (\alpha I - \alpha T)),$$

    où

    I est l'épaisseur de couche de la couche d'isolation (44, 48),
    P est l'épaisseur de couche de la couche en piézocéramique (46),
    $\alpha T$ est le coefficient de dilatation thermique du boîtier (35) dans la région partielle axiale du boîtier (35) dans laquelle se trouve l'élément piézoélectrique (41),
    $\alpha P$ est le coefficient de dilatation thermique de la couche en piézocéramique (46) et
    $\alpha I$ est le coefficient de dilatation thermique de la de la couche d'isolation (44, 48).

4.  Injecteur de carburant selon l'une quelconque des revendications 1 à 3,
    **caractérisé en ce que**
    le boîtier (35 ; 35a) est réalisé en forme de capot et présente un logement (43) pour le module (50), une couche d'isolation (48) s'appliquant au moins en partie contre un fond (51) du boîtier (35 ; 35a) et la profondeur (T) du logement (43) correspondant au maximum à l'épaisseur (D) du module (50).

5.  Injecteur de carburant selon la revendication 4,
    **caractérisé en ce que**
    l'élément piézoélectrique (41) s'applique, avec sa couche d'isolation (48) tournée vers le fond (51), sur toute sa surface contre le fond (51).

6.  Injecteur de carburant selon la revendication 4 ou 5,
    **caractérisé en ce que**

le boîtier (35) présente une bride périphérique (36) qui est connectée par une liaison par soudage (38) au boîtier d'injecteur (11), et **en ce que** la profondeur (T) du logement (43) est inférieure d'un espace de soudage (40) à l'épaisseur (D) du module (50).

**7.** Injecteur de carburant selon l'une quelconque des revendications 1 à 6,
**caractérisé en ce que**
le boîtier (35 ; 35a) se compose d'un matériau ayant un faible coefficient de dilatation thermique, de préférence d'Invar®.

**8.** Injecteur de carburant selon l'une quelconque des revendications 1 à 7,
**caractérisé en ce que**
le module (50) est reçu avec un jeu radial dans le boîtier (35 ; 35a) et **en ce qu'**au moins les couches d'électrodes (45, 47) présentent une isolation (52) du côté tourné vers le boîtier (35 ; 35a).

**9.** Injecteur de carburant selon la revendication 7 ou 8,
**caractérisé en ce que**
le module (50) pour guider les conduites de raccordement (53 ; 53a, 54 ; 54a) et pour réaliser des connexions (57, 58) avec les couches d'électrodes (45, 47) présente des alésages en forme de trou borgne (55 ; 55a, 56 ; 56a) de préférence réalisés par un processus d'usinage laser, les alésages (55 ; 55a, 56 ; 56a) traversant complètement la couche d'électrode respective (45, 47) et pénétrant jusque dans la couche d'isolation (44, 48) tournée dans la direction du boîtier d'injecteur (11).

**10.** Injecteur de carburant selon la revendication 9,
**caractérisé en ce que**
le boîtier (35 ; 35a) présente en affleurement avec les alésages (55 ; 55a, 56 ; 56a), des ouvertures de passage (59 ; 59a, 60 ; 60a) pour le passage des conduites de raccordement (53 ; 53a, 54 ; 54a), et **en ce que** l'espace intermédiaire entre les conduites de raccordement (53 ; 53a, 54 ; 54a) et les ouvertures de passage (59 ; 59a, 60 ; 60a) est rempli avec une masse d'isolation (61).

**11.** Injecteur de carburant selon la revendication 10,
**caractérisé en ce que**
les conduites de raccordement (53a, 54a) présentent dans la région des ouvertures de passage (59a, 60) un fil de raccordement (67) avec une portion (64) qui est réalisée avec un diamètre agrandi, **en ce que** le diamètre du fil de raccordement (67) est réduit dans la région des alésages (55a, 56a), **en ce que** la section transversale des ouvertures de passage (59a, 60a) est supérieure à la section transversale des alésages (55a, 56a) et **en ce que** la masse d'isolation (61) est réalisée de préférence sous la forme d'une fusion de verre (65).

**12.** Injecteur de carburant selon l'une quelconque des revendications 9 à 11,
**caractérisé en ce que**
les connexions (57, 58) sont réalisées sous forme de connexions brasées.

**13.** Injecteur de carburant selon la revendication 12,
**caractérisé en ce qu'**
entre les conduites de raccordement (53a, 54a) du côté tourné vers la couche d'électrode respective (45, 47) et la base de l'alésage respectif (55a, 56a), est réalisé un espacement (66) rempli de brasure.

**14.** Injecteur de carburant selon l'une quelconque des revendications 9 à 13,
**caractérisé en ce que**
les alésages (55 ; 55a, 56 ; 56a) sont disposés de manière asymétrique par rapport à un axe de symétrie (63) du module (50).

**FIG. 1**

FIG. 2

FIG. 3

**FIG. 4**

**FIG. 5**

**FIG. 6**

EP 3 088 723 B1

**IN DER BESCHREIBUNG AUFGEFÜHRTE DOKUMENTE**

**In der Beschreibung aufgeführte Patentdokumente**

- DE 102014209330 A1
- EP 3056724 A1
- EP 1530037 A1